# EUROPEAN PATENT APPLICATION

(11) **EP 2 699 065 A1**
(43) Date of publication of application: **19.02.2014**
(21) Application number: 12866412.5
(22) Date of filing: 18.06.2012
(51) Int. Cl.: H05K 1/02

(54) **CIRCUIT SUBSTRATE**

(71) Applicant: Sanyo Electric Co., Ltd., Moriguchi-shi, Osaka 570-8677 (JP)
(72) Inventor: SAITO, Takao, Moka City Tochigi 321-4397 (JP)
(74) Representative: Glawe, Delfs, Moll
(86) International application number: PCT/JP2012/065449
(87) International publication number: WO 2013/190604

(57) **Abstract**

[Problem] To provide a printed circuit board in which holes in a printed wiring can be readily filled with solder and the heat can be readily decreased , even if the printed wiring has a greater length or width.

[Solution] A printed circuit board (1) on which a plurality of electronic components are arranged, a printed wiring (2) for causing a current to flow between the electronic component being provided to the printed circuit board, the electronic components being connected using solder to the printed wiring (2) by soldering; the printed circuit board being characterized in that: a plurality of long holes (3) are provided, along the current flow, to the printed wiring (2); the long holes (3) form a first long hole row (31) along the direction of current flow, and a second long hole row (32) provided alongside the first long hole row (31); the long holes in the second long hole row (32) are provided so as to face a spacing between long holes that are disposed in series in the first long hole row (31); and the solder (8) fills the long holes in the first long hole row (31) and the long holes in the second long hole row (32).

## Description

### TECHNICAL FIELD

The present invention relates to a printed circuit board in which a plurality of electronic components are soldered to a printed wiring.

### BACKGROUND ART

Conventionally, there have been provided printed circuit boards in which a printed wiring is provided, and the wires of an electronic component such as a resistor or a capacitor is inserted into the through-hole provided to the printed wiring and soldered to connect an electrical circuit. A printed circuit board of such description is manufactured so as to constitute a variety of electronic circuits according to the electronic equipment.

For example, if the electronic circuit of a printed circuit board is intended to supply electrical power, a large current flows through the printed wiring. In such an instance, the heat is generated in the printed wiring by the large current flowing. This heat generation is affected based on the cross-section size of the printed wiring; the amount of heat is larger with a smaller size if the material is identical. Therefore, printed circuit boards for a large current are devised so that, e.g., the cross-section size of the printed wiring for the current is increased and the amount of heat is decreased.

For example, in the method disclosed in Patent Citation 1, a hole penetrating from the obverse side to the reverse side is provided to the printed wiring, and the hole is filled with solder. The printed circuit board disclosed in Patent Citation 1 is thereby imparted with a larger flow path for the current, and the cross-section size of the flow path, including the printed wiring, is increased, by the amount corresponding to the solder of the hole (Patent Citation 1).

[Patent Citation 1] Examined Utility Model Application Publication No. 7-47897

Specifically, one or two long holes are provided to the printed wiring that electrically links one electronic component to another electronic component, and the long holes are filled with solder. There is also disclosed an arrangement in which a plurality of small holes are arranged in a single row from one electronic component to another electronic component in a printed wiring, and all of the small holes are filled with solder.

### DISCLOSURE OF THE INVENTION

### [Problems the Invention Is Intended To Solve]

However, although the method disclosed in Patent Citation 1 is effective if the printed wiring pattern is short or has a small width, a printed wiring pattern actually channelling a large current requires a large width even if holes of such description are used, and the length may also increase depending on the positions at which the electronic components are arranged. In such an instance, the long holes on the printed circuit board disclosed in Patent Citation 1 will be longer (larger), and a larger amount of solder is required to fill the holes during soldering. Accordingly, the solder may flow out (fall under gravity) from the holes before setting, preventing the holes from being filled.

Also, if a plurality of small holes are filled with solder, in the portions between the small holes, the only flow path channelling the current is the printed wiring, and the area of the flow path is smaller; therefore heat is more likely to be highter. Casually providing the small holes when the printed wiring has a greater length or width will result in a collection of portions that readily generate heat, making it more difficult to suppress heat generation.

The present invention was conceived of the abovementioned problem, and an object of the present invention is to provide a printed circuit board in which holes in a printed wiring will be readily filled with solder and the heat generation will be readily suppressed, even if the printed wiring has a greater length or width.

### [Means for Solving the Abovementioned Problems]

In order to achieve the above-mentioned object, a printed circuit board according to an aspect of the present invention is a printed circuit board on which a plurality of electronic components are arranged, and a printed wiring for passing a current flow between the electronic components is provided, the electronic components being soldered on the printed wiring ; the printed circuit board being characterized in that: a plurality of long holes are provided, along the current flow, to the printed wiring; the long holes form a first long hole row along the direction of current flow, and a second long hole row provided alongside the first long hole row; the long holes in the second long hole row are provided in a corresponding manner so as to face a spacing between long holes that are disposed in series in the first long hole row; and the solder fills the long holes in the first long hole row and the long holes in the second long hole row.

According to a printed circuit board of the present invention, a plurality of long holes extending in the direction of current flow are provided to the printed wiring, and the long holes are filled with solder. It is thereby possible to divide the long holes into a plurality, making it possible to minimize the size of each of the long holes and to readily fill the long holes by solder. Since the long holes in the second long hole row are provided so as to face the portions between the long holes in the first long hole row, locations that readily generate heat (i.e., between the long holes) do not face each other. Therefore, sources of heat are dispersed, and generation of heat will be suppressed.

The above-mentioned invention is further characterized in that: the electronic components are arranged on an obverse surface; a rim portion of each of the long holes on the obverse surface is covered by solder resist; and a soldered part to which solder adheres is provided to a rim portion of each of the long holes on a reverse surface.

The above-mentioned invention is further characterized in that some of the long holes are provided to a single aforementioned soldered part and form the first long hole row.

The above-mentioned invention is further characterized in that the other long holes are provided to a single aforementioned soldered part, which is different from the soldered part of the first long hole row, and form the second long hole row.

The above-mentioned invention is further characterized in that a jumper wire is arranged straddling between two of the long holes that are disposed in series.

The above-mentioned invention is further characterized in that the gap between the long holes forming the first long hole row is shorter than the length of the long holes forming the second long hole row, and the gap between the long holes forming the second long hole row is shorter than the length of the long holes forming the first long hole row.

The above-mentioned invention is further characterized in that the lateral width of the long holes is 1.2 to 2.5 mm and the longitudinal length of the long holes is 10 to 30 mm.

### [Effect of the Invention]

According to the present invention, it is possible to provide a printed circuit board in which holes in a printed wiring can be readily filled with solder and heat generation will be readily suppressed, even if the printed wiring has a greater length or width.

### BRIEF DESCRIPTION OF THE DRAWINGS

FIG. 1 is a top view showing a portion of a printed circuit board;
FIG. 2 is an expanded view of portion W shown in FIG. 1;
FIG. 3 is a cross-section view of the printed circuit board along line A-A;
FIG. 4 is a cross-section view of the printed circuit board along line B-B;
FIG. 5 is an expanded view of portion X shown in FIG. 1
FIG. 6 is an expanded view of portion Y shown in FIG. 1
FIG. 7 is an expanded view of portion Z shown in FIG. 1

### BEST MODE FOR CARRYING OUT THE INVENTION

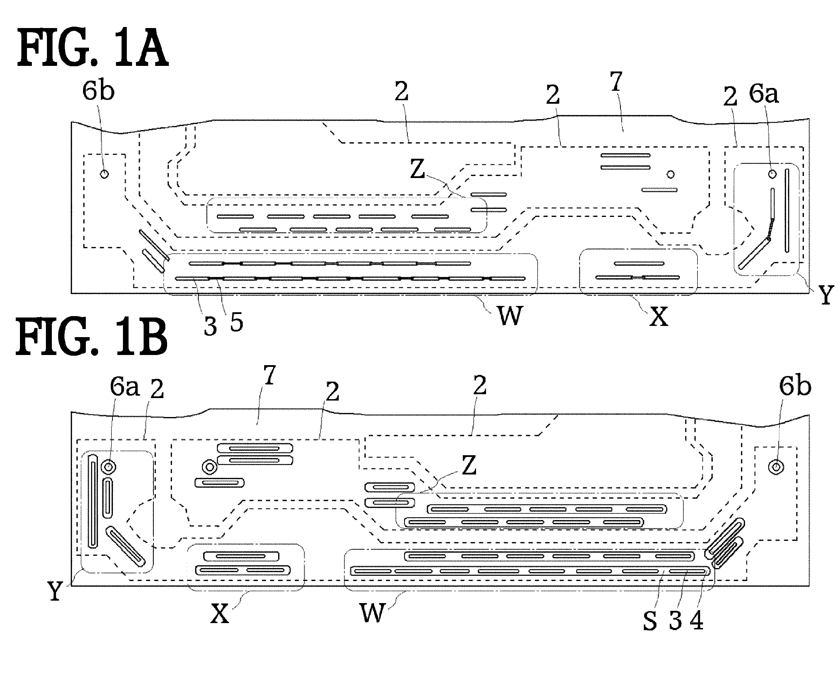

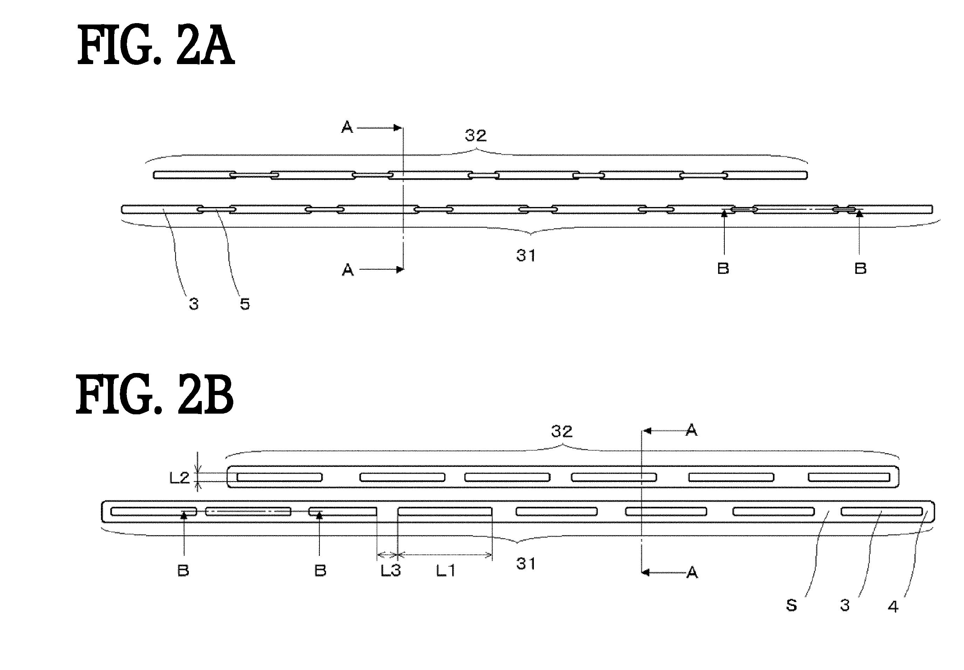

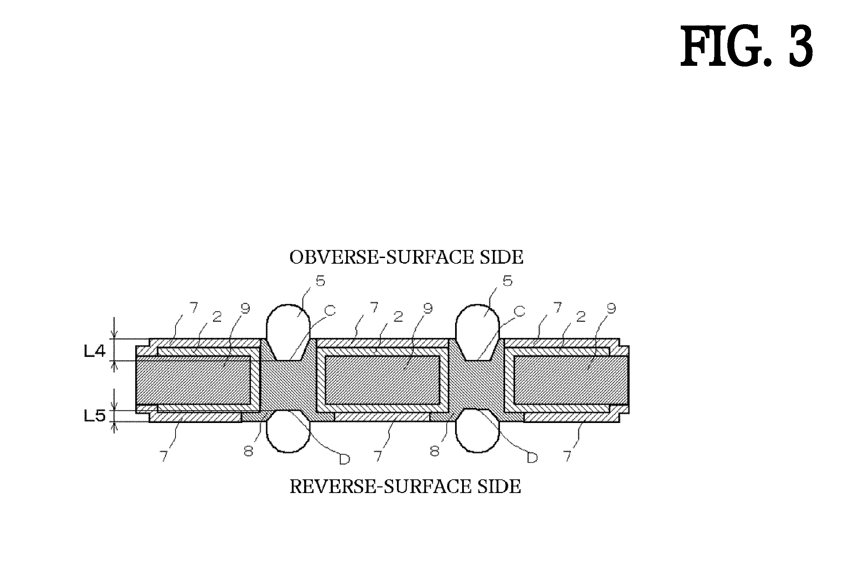

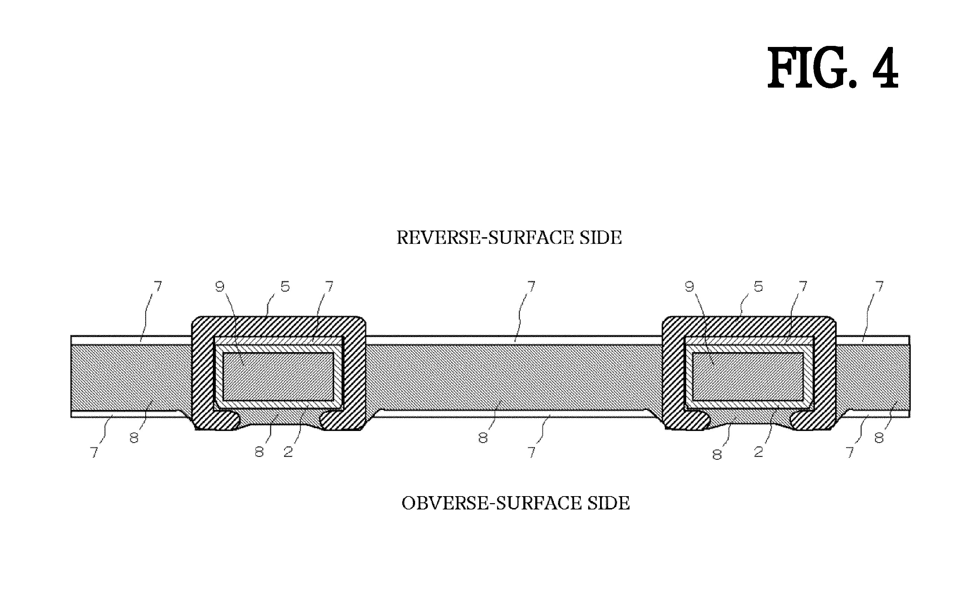

An embodiment of the present invention will now be described in detail with reference to the drawings. FIG. 1 is a top view showing a portion of a printed circuit board. FIG. 1(a) is a top view of an electronic component placement surface (obverse surface), and FIG. 1(b) is a top view of the reverse surface. FIG. 2 is an expanded view of portion W indicated in FIG. 1. FIG. 2(a) is an expanded view of portion W of the obverse surface, and FIG. 2(b) is an expanded view of portion W of the reverse surface. FIG. 3 is a cross-section view of the printed circuit board along line A-A. FIG. 4 is a cross-section view of the printed circuit board along line B-B. The printed circuit board 1 comprises a printed wiring 2, long holes 3, a soldered part 4, jumper wires 5 (metal line), through-holes 6, a solder resist 7, and a plurality of electronic components (not shown).

The printed wiring 2 is provided to the printed circuit board 1. The through-holes 6, to which the wires of an electronic component or a similar element is soldered, are made on the printed wiring 2. The printed wiring 2 is formed on each of the component placement surface (obverse surface) and the reverse surface of the printed circuit board 1 so as to be symmetrical to each other; a material that is a good conductor of electricity and adheres well with solder, such as copper, is used.

The wires of an electronic component or a similar element (e.g., capacitor, resistor, terminal platform, reactor, switch element, etc.) is inserted from the obverse surface into a through-hole 6, and the electronic component or similar element and the printed wiring 2 are connected to each other by soldering. The printed circuit board 1 thereby forms a predefined electrical circuit. In other words, the printed wiring 2 is provided to the printed circuit board 1 so that a desired electrical circuit is connected.

The through-hole 6a and through-hole 6b have different electronic components arranged thereto, and between the electronic components, a current flows along the printed wiring 2 between the through-holes 6. In FIG. 1, the printed wiring 11 is hidden by the solder resist 7 described further below, and is therefore indicated by dotted lines. The inner wall of the through-holes 6 is covered by a similar material to that forming the printed wiring 2 (e.g., copper, a copper alloy).

A plurality of long holes 3 are formed on the printed wiring 11 along the direction of current flow (i.e., along the printed wiring 11. The long holes are arranged on the printed wiring in two rows, forming a first long hole row 31 and a second long hole row 32. The long holes 3 in the second long hole row 32 are provided so as to face the spacing B between long holes 3 that are disposed in series in the first long hole row 31. The inner wall of the long holes 3 is coated by a similar material to that forming the printed wiring 2, and connects the printed wiring on the obverse surface and the printed wiring on the reverse surface to each other.

If the gap between long holes that are disposed in series is represented by L3 and the longitudinal length of each of the long holes 3 is represented by L1, the gap L3 is shorter than the length L1. In other words, the gap between long holes that are disposed in series forming the first long hole row 31 is shorter than the length of each of the long holes forming the second long hole row 32, and the gap between the long holes forming the second long hole row 32 is shorter than the length of each of the long holes forming the first long hole row 31.

On the obverse surface and the reverse surface of the printed circuit board 1, the printed wiring 2 is covered by a solder resist 7 made from an insulating material, and the obverse-surface side including the rim portions of the long holes 3 is covered by the solder resist. The rim portions of the long holes 3 on the reverse-surface side is covered by a solder resist 7 so as to leave rim portions exposed to allow solder to adhere through soldering. The printed wiring 2 on the rim portions of the long holes 3 form the soldered part 4. Although the soldered part 4 is provided using the printed wiring 11, another conductive member can be provided to the long holes 3 to form the soldered part 4.

The long holes in the first long hole row 31 (some of the long holes) are provided to a single soldered part, and form the first long hole row 31. The long holes in the second long hole row 32 (the other long holes) are provided to a single soldered part, different from the soldered part of the first long hole row, and form the second long hole row.

Jumper wires 5 straddling between two long holes 3 are arranged on the printed circuit board 1. Specifically, jumper wires 5 are arranged straddling neighboring long holes in the first long hole row 31. In the second long hole row, similarly, jumper wires 5 are arranged straddling two neighboring long holes in the second long hole row. Jumper wires 5 may also be arranged, each straddling a long hole in the first long hole row 31 and a neighboring long hole in the second long hole row 32.

Soldering is performed after the electronic components, the jumper wires 5, and similar elements are arranged on the printed circuit board 1. Soldering is performed, using lead-free solder, by dipping the reverse surface of the printed circuit board 1 into a solder bath of approximately 220°C to 270°C. The soldering fills the long holes in the first long hole row 31 and the long holes in the second long hole row 32 with solder 8, and blocks the long holes 3 (see FIGS. 3 and 4). The soldering causes the solder 8 to adhere to the soldered part 4 and solidify, and covers the soldered part 4 with solder. At this time, the portions of the jumper wires 5 that are inserted into the long holes 3 are embedded in solder and immobilized.

If the long holes 3 are too small when soldering is performed, the solder 8 intended to be charged into the long holes 3 will be prevented from being charged, and it will not be possible to fill the long holes 3 by the solder 8. If the long holes 3 are too large, the solder 8 intended to be charged into the long holes 3 will fall under gravity, and it will not be possible to fill the long holes 3 by the solder 8.

In order to sufficiently fill the long holes 3 with the solder 8, in the present embodiment, the lateral width L2 of the long holes 3 is set to about 1.2 to 2.5 mm, and the longitudinal length of the long holes 3 is set to about 10 to 30 mm.

Thus, in the present embodiment, a plurality of long holes 3 extending along the current flow direction is provided to the printed wiring 2, and the long holes 3 are filled using solder. The long holes 3 can thereby be divided into a plurality, making it possible to minimize the size of each of the long holes 3 and to readily be filled with solder 8. Since the long holes in the second long hole row 32 are provided so as to face the portions between the long holes in the first long hole row 31, locations that readily generate heat (i.e., between the long holes) do not face each other. Therefore, sources of heat are dispersed, and generation of heat can be suppressed.

Also, according to the present embodiment, the rim portions of the long holes 3 on the component-placement-surface side on which a plurality of electronic components are placed are covered by the solder resist 7. Therefore, even if the solder 8 spills out from the long holes, the solder is obstructed by the solder resist 7 on the obverse surface, and the solder 8 is less likely to adhere to the obverse surface. It is thereby possible to suppress instances in which the solder 8 comes between the printed wiring and the electronic component arranged on the obverse surface, and electricity is accidentally conducted.

The soldered part 4 is provided to the rim portions of the long holes 3 on the reverse surface so that the solder 8 can be applied by soldering. As a result, when the melted solder cools and solidifies, the solder flows under gravity onto the soldering part on the reverse surface, the solder 8 cools and decreases in volume, and the solder 8 charged in the long holes 3 indents, on the side towards the obverse surface of the printed circuit board 1, by about 0.3 mm to 0.5 mm (see label C in FIG. 3). If the solder 8 bulges outwards on the surface of the solder 8, there is a possibility of inadvertent conduction between the solder 8 and the electronic component. However, this indent C makes it possible to suppress instances of inadvertent conduction between the electronic component and the solder 8.

The solder 8 charged in the long holes 3 also indents on the side towards the reverse surface of the printed circuit board 1 by about 0.1 mm to 0.2 mm due to the solder 8 cooling and decreasing in volume (see label D in FIG. 3). The indents C and D having this size correspond to the degree of indentation that occurs when the long holes 3 are fully filled with the long holes 3, and this size indicates that it has been possible to obtain a large cross-section for the flow path channeling the current and that the effect of suppressing heat generation is sufficient. Conversely speaking the size of the long holes 3 can be determined so that the indent C measures 0.3 mm to 0.5 mm and the indent D measures 0.1 to 0.2 mm. In the present embodiment, the lateral width L2 of the long holes 3 is set to about 1.2 mm to 2.5 mm, and the longitudinal length of the long holes 3 is set to about 10 mm to 30 mm, whereby the indent C measures 0.3 mm to 0.5 mm and the indent D measures 0.1 to 0.2 mm.

Also, the soldered part 4 being coated by the solder 8 increases the cross-section size of the flow path channeling the current by an amount corresponding to the solder covering the soldered part 4; therefore, heat generation can be further suppressed.

According to the present embodiment, the long holes in the first long hole row 31 are provided in a single soldered part, and form the first long hole row. As a result, the spaces between the long holes in the first long hole row 31 are also covered by solder; therefore, the cross-section of the flow path channeling the current increases by a corresponding amount, and heat generation can be further suppressed.

According to the present embodiment, the long holes in the second long hole row 32 are provided in a single soldered part 4, different from the soldered part 4 of the first long hole row 31, and form the second long hole row 32. As a result, the spaces between the long holes in the second long hole row 32 are also covered by solder; therefore, the cross-section of the flow path channeling the current increases by a corresponding amount, and heat generation can be further suppressed.

According to the present embodiment, the gaps between the long holes forming the first long hole row 31 are shorter than the length of the long holes forming the second long hole row 32, and the gaps between the long holes forming the second long hole row 32 are shorter than the length of the long holes forming the first long hole row 31. The probability of the gaps between the long holes in the first long hole row and the gaps between the long holes in the second long hole row 32 facing each other is thereby reduced, sources of heating are dispersed, and generation of heat can be suppressed.

Since jumper wires are arranged straddling two of the long holes, the cross-section size of the flow path channeling the current between two long holes 3 is increased, and generation of heat can be suppressed.

According to the present embodiment, the printed wiring is present on the obverse surface and the reverse surface and forms a current path; therefore, the cross-section of the flow path channeling the current between two long holes is increased, and generation of heat can be suppressed.

Although a description of an embodiment of the present invention has been given above, the description given above is intended to facilitate understanding of the present invention, and is not intended to limit the present invention. It shall be apparent that the present invention may be modified or improved without departing from the scope thereof, and that the present invention includes equivalents thereof.

For example, the jumper wires used in the present embodiment may be replaced with a non-penetrating long groove.

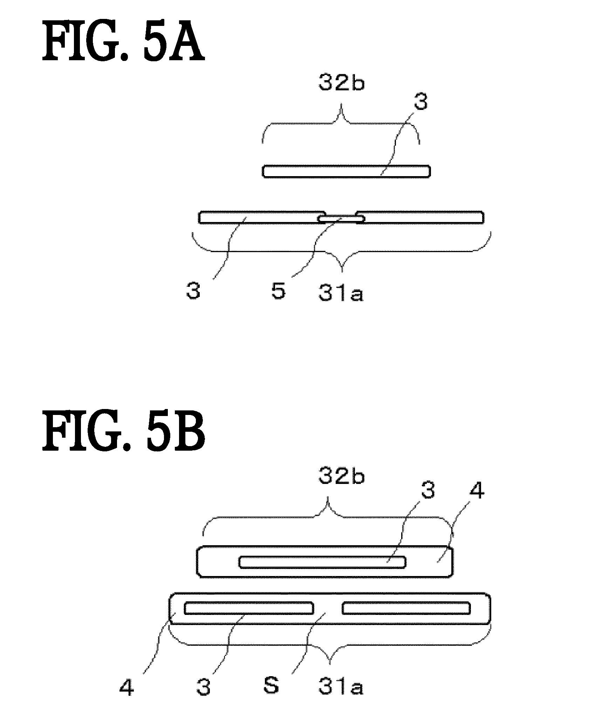

Also, for example, in the present embodiment, the second long hole row 32 is formed from a plurality of long holes 3. However, the second long hole row 32 may be formed from a single long hole 3. FIG. 58 is an expanded view of portion X shown in Fig. 1. FIG. 5(a) is an expanded view of portion X on the obverse surface, and FIG. 5(b) is an expanded view of portion X on the reverse surface. In these drawings, the second long hole row 32 is formed from a single long hole 3 as described above.

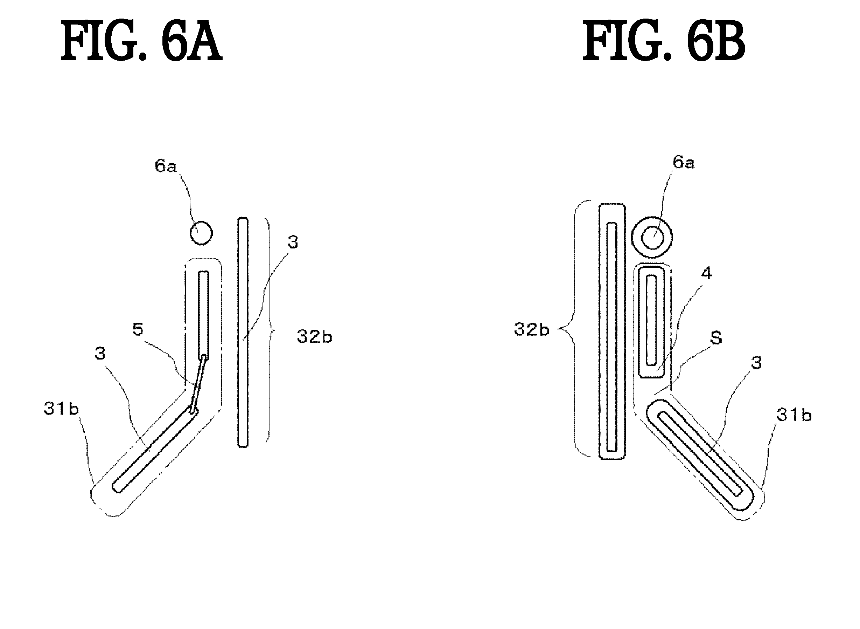

Also, for example, in the present embodiment, the first long hole row 31 and the second long hole row 32 are linear. However, long hole rows need only follow the flow path channeling the current (or the printed wiring 2). FIG. 6 is an expanded view of portion Y shown in FIG. 1. FIG. 6(a) is an expanded view of portion Y on the obverse surface, and FIG. 6(b) is an expanded view of portion Y on the reverse surface. In these drawings, the second long hole row 32b is arranged so as to bend along the flow path channeling the current, as described above.

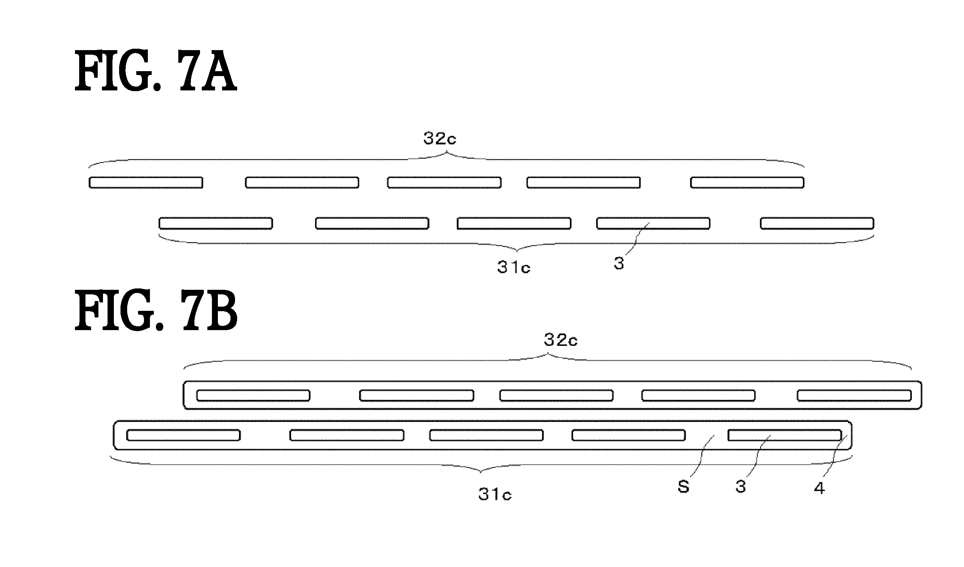

Also, for example, in the present embodiment, there are arranged jumper wires 5 straddling two long holes that are disposed in series in the first long hole row 31 or the second long hole row 32. However, as long as the effect of suppressing generation of heat can be sufficiently obtained, it is not a requirement that the jumper wires 5 are placed. FIG. 7 is an expanded view of portion Z shown in FIG. 1. FIG. 7(a) is an expanded view of portion Z on the obverse surface, and FIG. 7(b) is an expanded view of portion Z on the reverse surface. In these drawings, the jumper wires 5 are not placed, as described above.

Also, for example, in the present embodiment, the lateral width L2 of the long holes 3 is set to about 1.2 mm (lower limit) to 2.5 mm (upper limit), and the longitudinal length of the long holes 3 is set to about 10 mm (lower limit) to 30 mm (upper limit). However, the lower limit only needs to be set so that there is sufficient size for the solder 8 to be charged into the long holes 3 by soldering, and the upper limit only needs to be set so that the size does not cause the solder 8 to fall under gravity during soldering and form a void. In order to satisfy these requirements, the lateral width L2 of the long holes 3 can be set to about 0.7 mm to 3.5 mm, and the longitudinal length of the long holes 3 can be set to about 5 mm to 40 mm.

### [Key to Symbols]

- 1: printed circuit board
- 2: printed wiring
- 3: long hole
- 4: soldered part
- 5: jumper wire (metal wire)
- 6: through-hole
- 7: solder resist
- 8: solder
- 31: first long hole row
- 32: second long hole row

## Claims

1. A printed circuit board on which
a plurality of electronic components are arranged, and
a printed wiring for passing a current flow between the electronic components is provided, the electronic components being connected using solder to the printed wiring by soldering; the printed circuit board being **characterized in that**:
a plurality of long holes are provided, along the current flow, to the printed wiring;
the long holes form a first long hole row along the direction of current flow, and a second long hole row provided alongside the first long hole row;
the long holes in the second long hole row are provided in a corresponding manner so as to face a spacing between long holes that are disposed in series in the first long hole row; and
the solder fills the long holes in the first long hole row and the long holes in the second long hole row.

2. The printed circuit board according to claim 1, **characterized in that**:
the electronic components are arranged on an obverse surface;
a rim portion of each of the long holes on the obverse surface is covered by solder resist; and
a soldered part to which solder adheres is provided to a rim portion of each of the long holes on a reverse surface.

3. The printed circuit board according to claim 1 or 2, **characterized in that** the some of long holes are provided to a single the soldered part and form the first long hole row.

4. The printed circuit board according to claim 3, **characterized in that** the other long holes are provided to a single the soldered part, which is different from the soldered part of the first long hole row, and form the second long hole row.

5. The printed circuit board according to any of claims 1 through 4, **characterized in that** a jumper wire is arranged straddling two of the long holes that are disposed in series.

6. The printed circuit board according to any of claims 1 through 5, **characterized in that** the gap between the long holes forming the first long hole row is shorter than the length of the long holes forming the second long hole row, and the gap between the long holes forming the second long hole row is shorter than the length of the long holes forming the first long hole row.

7. The printed circuit board according to claim 1, **characterized in that** the lateral width of the long holes is 1.2 to 2.5 mm and the longitudinal length of the long holes is 10 to 30 mm.

## Amended claims

### Amended claims under Art. 19.1 PCT

**1.** A printed circuit board on which
a plurality of electronic components are arranged, and
a printed wiring for passing a current flow between the electronic components is provided,
the electronic components being connected using solder to the printed wiring by soldering; the printed circuit board being **characterized in that**:
a plurality of long holes are provided, along the current flow, to the printed wiring ;
the long holes form a first long hole row along the direction of current flow, and a second long hole row provided alongside the first long hole row;
and
the solder fills the long holes in the first long hole row and the long holes in the second long hole row.

**2.** The printed circuit board according to claim 1, **characterized in that** the long holes in the second long hole row are provided in a corresponding manner so as to face a spacing between long holes that are disposed in series in the first long hole row.

**3.** The printed circuit board according to claim 1 or 2, **characterized in that**:
the electronic components are arranged on an obverse surface;
a rim portion of each of the long holes on the obverse surface is covered by solder resist; and
a soldered part to which solder adheres is provided to a rim portion of each of the long holes on a reverse surface.

**4.** The printed circuit board according to any of claims 1 through 3, **characterized in that** the some of long holes are provided to a single the soldered part and form the first long hole row.

**5.** The printed circuit board according to any of claim 4, **characterized in that** the other long holes are provided to a single the soldered part, which is different from the soldered part of the first long hole row, and form the second long hole row.

**6.** The printed circuit board according to any of claims 1 through 5, **characterized in that** a jumper wire is arranged straddling two of the long holes that are disposed in series.

**7.** The printed circuit board according to any of claims 1 through 6, **characterized in that** the gap between the long holes making the first long hole row is shorter than the length of the long holes making the second long hole row, and the gap between the long holes making the second long hole row is shorter than the length of the long holes making the first long hole row.

**8.** The printed circuit board according to claim 1, **characterized in that** the lateral width of the long holes is 1.2 to 2.5 mm and the longitudinal length of the long holes is 10 to 30 mm.
